# EUROPEAN PATENT APPLICATION

(11) **EP 1 791 133 A1**
(43) Date of publication of application: **30.05.2007**
(21) Application number: 06124410.9
(22) Date of filing: 20.11.2006
(51) Int. Cl.: G11C 29/48, G11C 29/14

(54) **A method of sharing testing components for multiple embedded memories and the memory system incorporating the same**

(30) Priority: 29.11.2005 IN DE31992005
(71) Applicant: STMicroelectronics Pvt. Ltd., 201308 Greater Noida, Uttar Pradesh (IN)
(72) Inventor: Kashyap, Amit, 248001, Dehradun, Uttar Pradesh (IN); Dubey, Prashant, Ghaziabad, Uttar Pradesh (IN); Garg, Akhil, Dadri, GB Nagar, UP-203207 (IN)
(74) Representative: Jorio, Paolo

(57) **Abstract**

The present invention relates to a method of sharing testing components for multiple embedded memories and the memory system incorporating the same.

The memory system includes multiple test controllers, multiple interface devices, a main controller, and a serial interface. The main controller is used for initializing testing of each of the dissimilar memory groups using a serial interface and local test controllers. The memory system results in reduced routing congestion and faster testing of plurality of dissimilar memories.

## Description

### FIELD OF THE INVENTION

The present invention relates to the field of testing embedded memories. In particular, it discloses a methodology for sharing of testing components for multiple type of memories.

### BACKGROUND OF THE INVENTION

The memories are becoming major part of any Application-Specific Integrated Circuits (ASIC) today. As integrated circuit technology has advanced, the complexity and density of circuit devices formed within a single integrated circuit (IC) has increased dramatically. Consequently, several problems have arisen with regard to testing ICs. For example, while the conventional methodology for testing a memory array within an IC may be relatively straight forward, ICs typically have far fewer I/O pins available to an external circuit tester than are required to adequately test the memory array.

A general solution to the above-described and other difficulties with external testing is to embed test circuitry within the IC itself. Such integrated testing facilities are frequently referred to as built-in self-test (BIST), array self-test (AST), or array built-in self-test (ABIST) circuits and will hereinafter be referred to generically as BIST circuits.

Although the integration of BIST circuits within ICs facilitates IC testing, a central concern associated with BIST circuits is the large amount of die size consumed by the BIST circuit and associated circuitry. This concern is magnified as the number of memory arrays and other subcircuits integrated within an IC that require BIST testing multiply. This concern is particularly significant for state-of-the-art integrated circuits, such as a microprocessors and Application-Specific Integrated Circuits (ASICs), which commonly contain hundreds or thousands of relatively small memory arrays each requiring BIST testing.

The aforementioned problem was solved in US 20040268198 by having a common controller which controls the test activities on the entire chip while supporting a broad range of memory types like single port, dual port, register files and Rom. This is possible only due to a proper partitioning of the whole BIST system. However, the shared approach of this integrated circuit has a lot of parallel connections and hence occupies a lot of area due to routing congestion.

The concept of BIST is used for at-speeds equivalent to its application speed. Having a controller per BIST to run the desired algorithm as well as manage the repair activities will result in increaseed area and hence an increase in overall testing cost. Also more efforts will be needed at the time of chip integration. Thus various state of the art solutions are being given to share the test and repair resources across the plethora of memories on the chip. But then due to improper partitioning of the whole structure, the ultimate implementation becomes cumbersome as well as routing congestion prone as well as less than at-speed.

In existing architectures, the controller is embedded inside the BIST which controls the Test activities. As the algorithm for testing single and dual port memories are different, the controller inside the BIST is hard coded for the desired algorithm. Thus the controller's architecture changes from one memory type to other. As these controllers are replicated, for all the memories it results in lot of silicon area.

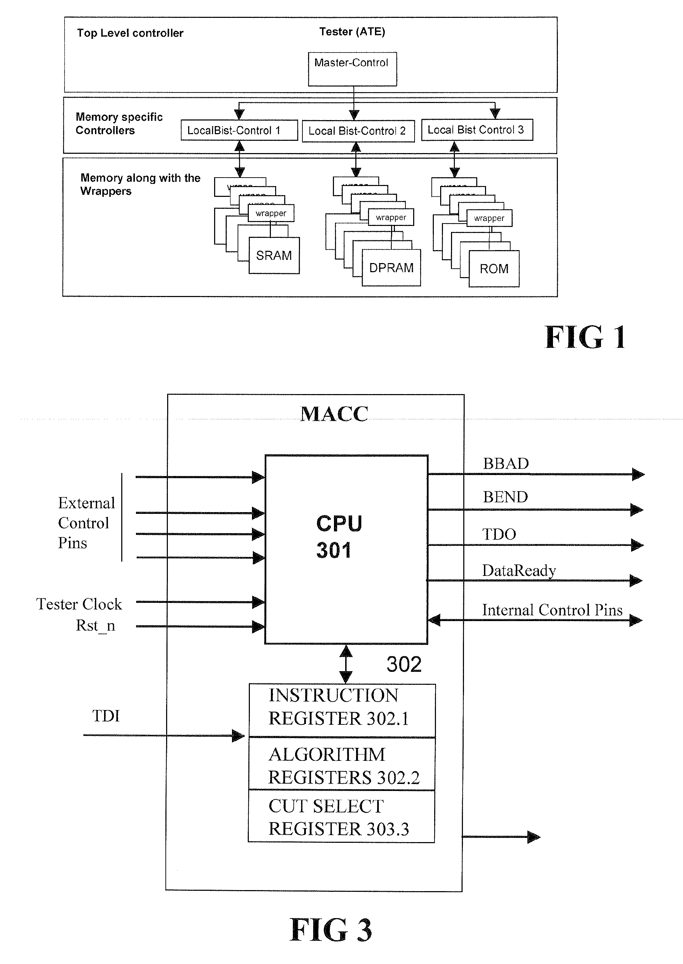

Figure 1 depicts the general idea behind the existing shared BIST architecture. In this architecture there is a common controller, which is meant to interact with the tester only. The different memory groups either have their different controllers or have the dedicated collars for the algorithm and then all the memories are connected in parallel which increase the routing congestion and thus makes the BIST architecture highly floor plan dependent.

The following are the drawbacks of the current methodologies:
- This shared approach occupies a lot of area due to routing congestion as there are a lot of parallel connections.
- The Shared approach cannot be used between many memories.
- Makes the BIST highly floorplan dependent as only the memories which are nearby to each other can be shared.
- Memories of different clock domain cannot be shared.
- For small memories, with large word widths, the gains are not much as the collar area cannot be reduced. Also, it cannot be shared between various memories.
- Different types of memories cannot be shared.
- At-speed testing is not possible easily. Either a lot of area is wasted to achieve the at-speed testing or the at-speed testing is not possible at all.
- Integration is a big issue for the user as the BIST area and performance becomes chip floorplan dependant.
- As more parallel lines are running for long distances, BIST defects can itself lower the yield of the chip.
- The shared BIST methodology cannot be easily programmable or if the programmability is added a lot of area is wasted.

The present invention solves the above problem by having a common controller which controls the test activities on the entire chip while supporting a broad range of memory types like single port, dual port, register files and ROM. This is possible only due to a proper partitioning of the whole BIST system. The at-speed parts are kept near the memory, while the static or low speed parts are shared. This results in significant area saving, thus reduces the test cost.

### SUMMARY AND OBJECTIVE OF THE INVENTION

It is an objective of the present invention to provide a memory system and a method of sharing test components for multiple embedded memories.

It is another objective of the present invention to provide a memory system having Built-In Self Test utilizing minimum area.

It is yet another object of the present invention to provide a memory system having an efficient subsystem for testing of memories.

It is still another objective of the present invention to provide a memory system, with Built-In Self Test for any size of the memory and any number of memories.

It is a further objective of the present invention to provide a memory system, with Built-In Self Test for multiple embedded memories (FITSMEM), which is floor plan independent.

To meet the aforementioned objectives the present invention provides a memory system comprising:
- a plurality of dissimilar memory groups each having at least one memory type;
- a plurality of local test controller each coupled to at least one of said similar memories;
- a plurality of interface devices coupled to one of said dissimilar memory groups;
- a main controller for randomly initializing one of said local test controllers for testing each of said dissimilar memory groups; and
- a serial interface connecting all said local test controllers and main controller in a ring configuration for said random initialization.

In another aspect of the present invention provides a method for testing multiple memories embedded in a chip comprising the steps of:
- partitioning of the memories in said shared memory test architecture into a plurality of dissimilar memory groups;
- initializing a plurality of local test controllers associated with one of said dissimilar memory groups by a main controller;
- testing memories using initialized local test controllers;
- generating a control signal associated with said initialized local test controllers for the main controller on completion of said step of testing;
- repeating said steps of initializing, testing and generating for each of said plurality of dissimilar memory groups; and
- transferring the status of said plurality of dissimilar memory groups to the main controller.

### BRIEF DESCRIPTION OF THE ACCOMPANYING DRAWINGS

While the specification concludes with the claims, it is believed that the invention will be better understood from the following descriptions which are taken in conjunction with the accompanying drawings in which like designations are used to designate substantially identical elements.
Figure 1 is a block diagram of a shared BIST architecture as per prior art.
Figure 2 illustrates a memory system according to the present invention.
Figure 3 is a block diagram of the main controller of said memory system.
Figure 4 is a block diagram of the local test controller of said memory system.
Figure 5 illustrates a block diagram showing the arrangements of LUIS of said memory system.
Figure 6 illustrates a flow diagram of a method, according to the present invention.

### DETAILED DESCRIPTION OF THE INVENTION

This invention relates to a memory system which provides Floorplan Independent Built-In Self Test for Multiple Embedded Memories (FITSMEM), using shared test components.

One common controller on the chip controls the test activities of all the memories. The main idea behind the invention is the partitioning of the existing Memory BIST architecture. The partitioning is based upon separating out the at-speed memory. Size dependent parts like Address generator, Data Generator, Comparator and Control Fsm are kept near the memory. These parts combine to form a configurable collar in which the algorithms are programmable. This reduces the collar size drastically.

The information which is not memory size dependant and also which has to be applied at slow speed like algorithm march element, stress pattern, direction of the march element and number of the operation in the march element are kept at a central place and programmed each time, through a serial interface.

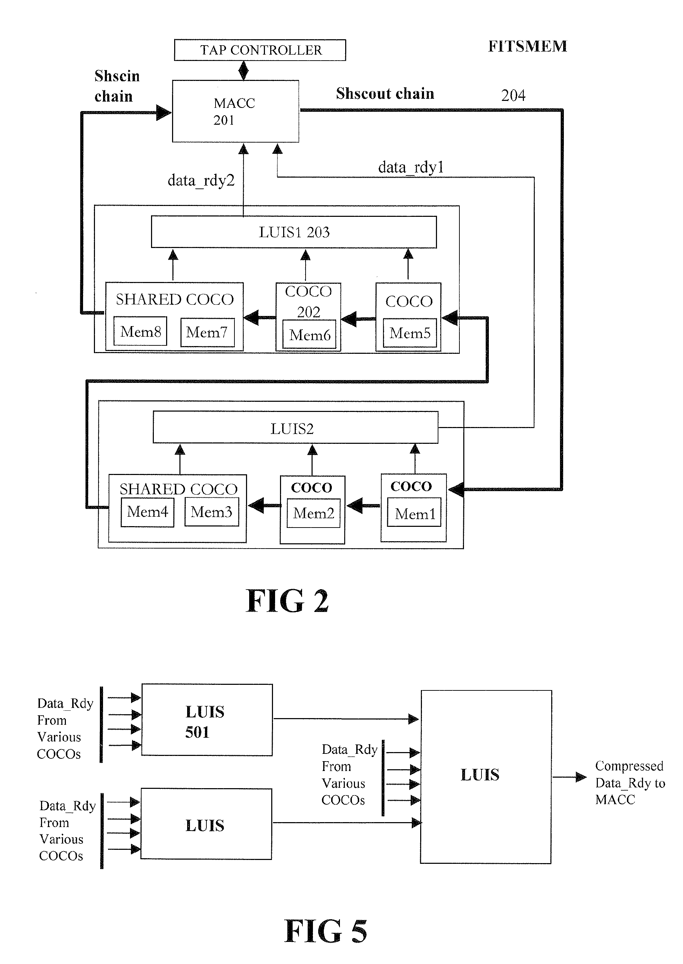

Figure 2 is a diagram for a memory system showing the connection between the major components of said architecture i.e. main controller or MACC (201), local controller or COCO (202) and interface device or LUIS (203) on chip. The memories, which have to be tested are coupled with the corresponding COCO. The COCOs are inter-connected serially in the form of a Chain (204) across the chip. The invention also teaches the sharing of a COCO among memories of the same size to further reduce the area. It is also possible to share the serial interface of COCOs of memories that are of the same type but different in size, to reduce the area further. However, there may be a trade off with respect to routing congestion.

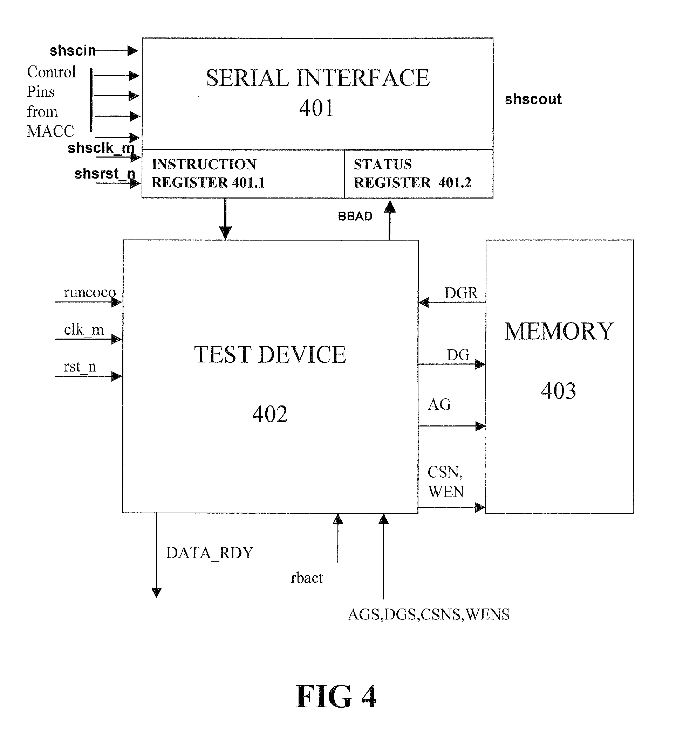

Figure 3 shows a block diagram of the main controller of said memory system. The main controller consists of a central processing unit (301) handling all the memories on chip. The main controller also consists of a plurality of registers blocks (302) having instruction register (302.1), algorithm register (302.2) and cut select register (302.3). The central processing unit (301) generates a set of control signals for the other components of the shared architecture responsive to the external control pins, tester clock and request_in. Cut selection, algorithm selection, algorithm configurations are performed by programming the MACC. The, MACC applies a particular selected algorithm, on the selected cuts on the chip. These features augment the capability of the MACC as a diagnostic mechanism as well as enables a power conscious test circuit.

Figure 4 shows a block diagram of the local test controller of said memory system. The two main parts of the local test controller are:
Serial Interface block (401): The Serial Interface has main Registers like instruction register (401.1) and status register (401.2) which can be programmed by selecting the appropriate mode. The Serial Interface is working on shsclk_m, which is a low frequency clock. The serial interface receives the control signals from main controller (301) through the control pins and generates an output signal shscout.
Test device or COCO Collar (402): Depending upon the March elements programmed in the instruction register (401.1) of the Serial Interface the COCO collar performs the operation on the memory and after the end of March run generates the asynchronous data ready signal for the MACC to signify the end of operation. The test controller block generates a set of control signals for the memory (403). The COCO collar is running at clk_m to support at speed testing as this is a high speed clock at which the memory will run during its application. Thus COCO collar supports at speed testing of the memories.

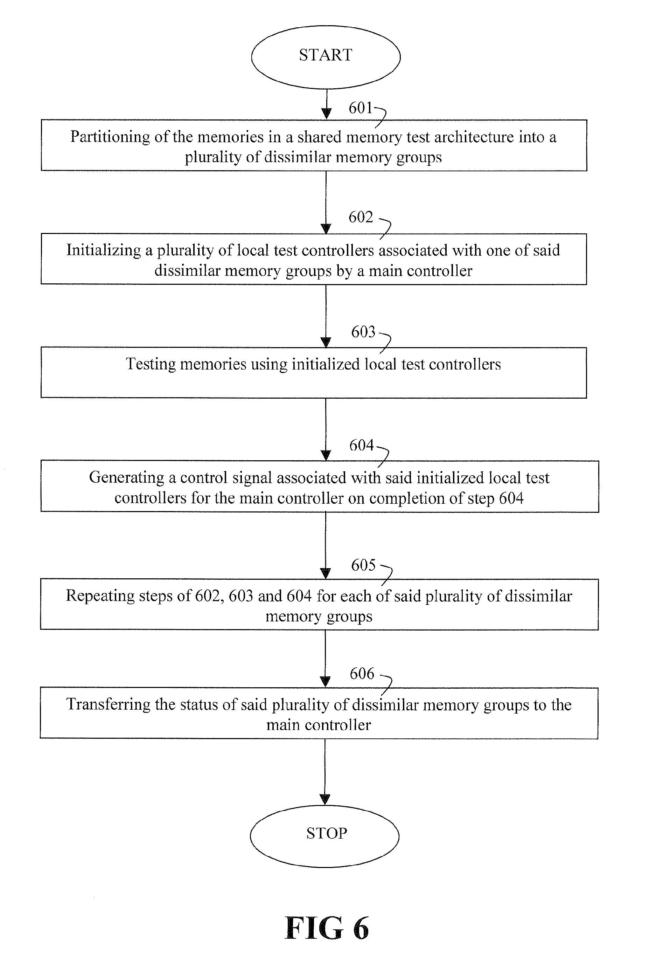

Figure 5 is a block diagram showing the arrangements of LUIS (501) of said memory system. The LUIS or interface device acts as a handshake between the COCOs or test controller and the MACC or main controller. This handshake is implemented by giving out a dataready signal from each COCO. Thus, whenever a particular task is finished or a data is ready to be released by a COCO, it sets a dataready flag to alert the MACC. The LUIS is provided to reduce the routing congestion arising from the large number of dataready pins. The LUIS monitors the dataready status of each memory and generates one data ready status for the MACC. The Outputs of multiple LUIS can be fed to one LUIS to reduce the congestion further.

The following is a general flow of running the memory system:
Program the Cut Select Register in the MACC for Memories which needs to be tested during the current run.
Make the ordering of the Cuts in the Cut Select Register is in the same order as the order in which the COCOs are connected in the serial interface or chain on the chip.
Program the Instruction register to select a particular Algorithm.
When MACC goes in the run mode it programs the March elements of the selected algorithm in the serial interface of the COCO for memory testing.
While programming the Cut select register to Run the COCO of one memory type, bypass COCO of the other types of memory.
Bypass the Serial Interface of the bypassed COCO by programming the corresponding bypass bit to '1' in order to bypass its serial chain. The FSM of these COCO collar will not run.
When the MACC has gone into the Run mode it waits for the data ready signal from the LUIS.
After receiving the data ready signal from the LUIS, the MACC goes in the capture mode to capture the good/bad status of the memory in the status register of the COCO serial Interface.
This status can then be shifted out to decide which of the selected cut is good or bad.
Once the Algorithm is over the MACC signifies the end of operation using bend signal otherwise MACC again pings the COCO for the next march elements of the selected algorithm.

Figure 6 illustrates a flow diagram of the working of the present invention. In step 601 the multiple embedded memories are partitioned on the basis of speed, memory size, dependent parts, etc., resulting in a plurality of dissimilar memory groups. In step 602 the main controller randomly initializes a plurality of local test controllers associated with one of the dissimilar memory groups. The initialized local test controllers are used for testing the associated memories in step 603. Each of said local test controllers associated with a dissimilar memory group generates a control signal on completion of testing. The plurality of control signals are combined to form a single control signal for the main controller in step 604. Steps 602 to 604 are repeated for each of said plurality of dissimilar memory groups in step 605. Finally, the status of the plurality of dissimilar memory groups are transferred to the main controller in step 606.

The present invention is not to be limited in scope by the specific embodiments and examples which are intended as illustrations of a number of aspects of the invention and any embodiments which are functionally equivalent are within the scope of this invention as defined by the appended claims. Those skilled in the art will know, or be able to ascertain using no more than routine experimentation, many equivalents to the specific embodiments of the invention described herein. These and all other equivalents are intended to be encompassed by the following claims.

## Claims

1. A memory system comprising:
- a plurality of dissimilar memory groups each having at least one memory type;
- a plurality of local test controllers each coupled to at least one of said memory types for generating a control signal;
- a plurality of interface devices coupled to one of said dissimilar memory group for receiving said control signals;
- a main controller for randomly initializing one of said local test controllers for testing each of said dissimilar memory groups; and
- a serial interface connecting all said local test controllers and main controller in a ring configuration for said random initialization.

2. The memory system as claimed in claim 1, wherein the plurality of local test controller comprising:
- a serial interface block operating on a first clock for said main controller having a plurality of storage devices; and
- a test device connected to said serial interface block operating on a second clock for testing said memory type and generating a control signal for the main controller.

3. The memory system as claimed in claim 1, wherein the main controller comprising:
- a central processing unit for initializing test on all the memories;
- a plurality of registers coupled to said central processing unit for configuring testing of said memories.

4. The memory system as claimed in claim 1, wherein the plurality of interface devices comprising multiplexer devices for combining said control signals from plurality of said local test controllers associated with one of said dissimilar memory groups.

5. The memory system as claimed in claim 2, wherein said first clock having an operating frequency lower than an operating frequency of said second clock.

6. The memory system as claimed in claim 3, wherein the plurality of registers comprising:
- an algorithm register for configuring test algorithm for said main controller;
- a cut select register for configuring selection of memories under test for said architecture; and
- an instruction register for selecting instructions for algorithm in said algorithm register.

7. The memory system claimed in claim 1, wherein said memory types are categorized based on required memory test algorithm.

8. A method for testing multiple memories embedded in a chip comprising the steps of:
- partitioning of the memories in said shared memory test architecture into a plurality of dissimilar memory groups;
- initializing a plurality of local test controllers associated with one of said dissimilar memory groups by a main controller;
- testing memories using initialized local test controllers;
- generating a control signal associated with said initialized local test controllers for the main controller on completion of said step of testing;
- repeating said steps of initializing, testing and generating for each of said plurality of dissimilar memory groups; and
- transferring the status of said plurality of dissimilar memory groups to the main controller.

9. The method as claimed in claim 8, wherein said generating comprises combining control signals generated by each of said localized test controller.
